# EUROPEAN PATENT APPLICATION

(11) **EP 4 753 147 A1**
(43) Date of publication of application: **03.06.2026**
(21) Application number: 25210909.5
(22) Date of filing: 23.10.2025
(51) Int. Cl.: H03F 3/08, H04B 10/69

(54) **TRANSIMPEDANCE AMPLIFIERS**

(30) Priority: 02.12.2024 US 202418965640
(71) Applicant: Semtech Corporation, Camarillo CA 93012-8790 (US)
(72) Inventor: NUTTGENS, Jonah Edward, Romsey, SO51 0PR (GB)
(74) Representative: Haseltine Lake Kempner LLP

(57) **Abstract**

This application relates to transimpedance amplifier circuits, which include a frontend amplifier (103) that receives an input current (I_{IN}) and output a corresponding voltage (V_{TIA}), and a processing stage (302) configured to process the voltage output from the frontend amplifier. The application relates to amplifier circuit in which the processing stage has a filter (303) with a frequency response (305) with a local minimum. The transimpedance amplifier circuit may be used to process a signal comprising data within a data frequency band and the filter may be configured such that the local minimum is within the data frequency band. The filter response at least partly compensates for a resonant peak in the frequency response (304) from the frontend amplifier due to an expected resonance at the input to the frontend amplifier.

## Description

### Technical Field

The present disclosure is related to apparatus and methods for transimpedance amplifiers and to transimpedance amplifier circuits.

### Background

Transimpedance amplifiers (TIAs) are used in a number of different applications. For example, TIAs are commonly used in optical receivers for optical data communication, where the optical receiver receives a data signal in the form of modulated optical radiation. The optical receiver typically includes a photodiode arranged to convert the received optical signal into a photocurrent and a TIA arranged to convert the photocurrent to a voltage, which may often be a differential voltage, that can be processed by downstream circuitry to recover the encoded data.

A key performance metric of a TIA is its sensitivity, i.e. how small an input signal it can be used to recover at an acceptable error rate or signal-to-noise ratio (SNR). The sensitivity of a TIA may typically be determined to a large extent by its input-referred-noise (IRN) characteristics. In general, therefore, it is advantageous to minimize the IRN figure of a TIA, particularly in a frequency band for the signal of interest for a given application.

Embodiments of the present disclosure relate to methods and apparatus for transimpedance amplifiers with improved sensitivity and/or noise performance.

### Summary

According to some embodiments there is provided a transimpedance amplifier circuit comprising a frontend amplifier configured to receive an input current from an input terminal and output a corresponding voltage and at least one processing stage configured to process the voltage output from the frontend amplifier. The at least one processing stage comprises a filter configured to provide a filter response having a frequency response with a local minimum.

The transimpedance amplifier circuit may be configured to process a signal comprising data within a data frequency band and the filter may be configured such that the local minimum is within the data frequency band. The filter may be configured such that the filter response at least partly compensates for a resonant peak in the frequency response from the frontend amplifier due to an expected resonance at the input to the frontend amplifier. The filter may be configured such that the local minimum substantially corresponds to an inverse of a resonant peak in the frequency response of the frontend amplifier that would be expected, in use, with a series inductance of a first defined value connected to the input terminal. The filter may be configured such that the filter response comprises two complex conjugate zeroes in the s-domain which are matched to two complex conjugate poles in a transfer characteristic of the frontend amplifier that would occur, in use, with a series inductance of a first defined value connected to the input terminal.

In some implementations, the transimpedance amplifier circuit may further comprise an inductance in series between the input terminal and the frontend amplifier. The inductance in series between the input terminal and the frontend amplifier may comprise at least part of an input resonant network. The filter may be configured such that the local minimum substantially corresponds to an inverse of a resonant peak of said input resonant network.

In some examples, the filter may comprise a notch filter with a non-zero transfer function at a notch frequency of the notch filter. In some examples, the filter may comprise a passive LC filter. In some examples, the filter may comprise a common source or common emitter amplifier and may further comprise a frequency-dependent degeneration network comprising a parallel combination of an inductor and a capacitor.

In some examples, the filter may comprise a first capacitance and an active inductor network each connected to a first filter node. The first filter node may be coupled to a source of a common-source amplifier or an emitter of a common-emitter amplifier. The active inductor network may comprise a second capacitance. At least one of the first capacitance and second capacitance may be configured to be controllably variable so as to vary the filter response of the filter. At least one the first capacitance and second capacitance may comprise a varactor.

In some implementations, at least one parameter of the filter is controllably variable so as to vary the filter response of the filter. The transimpedance amplifier circuit may further comprising a controller for controlling, in use, the at least one parameter of the filter, such that the local minimum in the filter response at least partially compensates for a peak in the frequency response of the frontend amplifier due to a resonance at the input to the frontend amplifier.

Aspects also include a data receiver apparatus the transimpedance amplifier circuit of any of the embodiments discussed herein, a data receiver configured to configured to receive a modulated data signal and generate a corresponding current; and an electrical interconnect for connecting an output of the data receiver to the input terminal of the transimpedance amplifier circuit. The data receiver and electrical interconnect may form at least part of an input resonant network and the data receiver apparatus may be configured such that the local minimum in filter response corresponds to an inverse of a resonant peak in the frequency response of said input resonant network. The data receiver apparatus may be configured as an optical receiver, in which case the data receiver may be a photodiode. In some implementations, the electrical interconnect may have a value of inductance such that said resonant peak is within a frequency band for the data signal.

In another aspect, there is provided a transimpedance amplifier circuit comprising a frontend amplifier configured to receive an input current from an input terminal and output a corresponding voltage and at least one processing stage configured to process the voltage output from the frontend amplifier. The at least one processing stage comprises a filter having a filter frequency response with a local minimum configured to compensate for a resonance peak in the frequency response of the frontend amplifier that would occur, in use, with a series inductance of a first defined value connected to the input terminal.

In a further aspect, there is provided a transimpedance amplifier circuit comprising a frontend amplifier and at least one processing stage in a signal path downstream of the frontend amplifier. The at least one processing stage comprises a filter having a frequency response configured to at least partly compensate for expected peaking arising, in use, from a resonant network connected to an input of the frontend amplifier.

### Brief Description of the Drawings

To better explain various embodiments and examples of the present disclosure and the principles, example implementation and operation thereof, reference will now be made, by way of example, to the following drawings, in which:
Figure 1 illustrates generally one example of a conventional TIA as part of an optical receiver;
Figure 2 illustrates a model of the input of the TIA;
Figure 3 illustrates one example of a TIA with a compensation filter according to an embodiment;
Figures 4a to 4d illustrate different examples of alternative general compensation filter;
Figure 5 illustrates an example of a suitable compensation filter with an active inductor;
Figure 6 illustrates an example of a suitable compensation filter with a tuneable filter response; and
Figure 7 illustrates an example of a differential compensation filter with a tuneable filter response.

### Detailed Description

Embodiments of the present disclosure relate to transimpedance amplifiers (TIAs), in particular to TIAs with some filtering to mitigate effects of a peaking response associated with some input inductance.

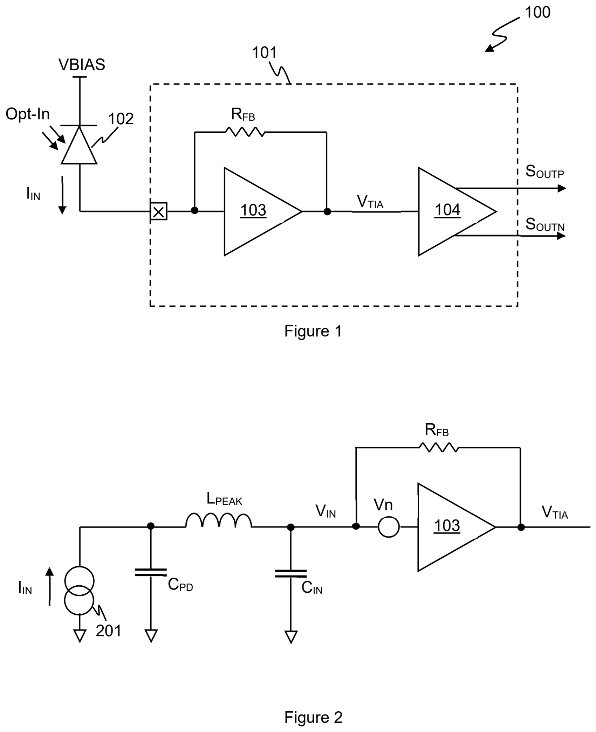

**Figure 1** illustrates one example of at least part of a data receiver apparatus 100, which in this example is an optical receiver, including a TIA 101. Figure 1 illustrates that the apparatus 100 has a data receiver, which in this case is a photodiode 102 which is configured to receive a modulated optical data signal Opt-In, from an optical data path (not shown) that may be implemented, at least partly, by a fibre optic cable. The photodiode 102 converts the optical signal Opt-In to a corresponding photocurrent I_{IN} which is supplied to the TIA 101.

The TIA 101 has a frontend amplifier 103 which, in the example of figure 1, is implemented in a shunt-feedback configuration with a feedback resistance R_{FB}, as will be understood by one skilled in the art. The TIA frontend amplifier 103 is configured to convert the input current I_{IN} to a corresponding voltage V_{TIA}. The TIA 101 also comprises at least one backend processing stage, which in the example of figure 1 can provide single-ended to differential conversion to provide a differential output signal with components S_{OUTP} and S_{OUTN}. The backend stage(s) 104 may additionally or alternatively provide functions such as additional amplification, filtering, equalization, automatic gain control, limiting etc. as would be understood by one skilled in the art. The backend stage(s) 104 may comprise an output stage with an impedance-matched differential line driver for outputting the output signal for downstream processing, e.g. for demodulation or clock and data recovery.

A key performance metric for the TIA 101 is the sensitivity, i.e. how small an input signal can be recovered with an acceptable error rate or SNR. A relatively important parameter for the TIA sensitivity is input-referred noise (IRN).

**Figure 2** illustrates a simplified small-signal model of the input for the TIA illustrated in figure 1. The photodiode 102 is modelled as a current source 201 providing the input current I_{IN} together with a parallel capacitance C_{PD} representing the capacitance of the photodiode. The model also includes an input capacitance C_{IN} for the frontend amplifier 103 and a series inductance L_{PEAK} in the coupling between the photodiode and frontend amplifier 103. This inductance L_{PEAK} may arise due to the electrical interconnect between the photodiode and the frontend amplifier 103, e.g. from a bond-wire coupling the photodiode to an integrated circuit comprising the TIA, and the value of inductance L_{PEAK} may thus depend on the length of the relevant interconnect. One main contributor to the IRN is modelled as a voltage Vn applied at the input to the frontend amplifier 103 (another being the Johnson noise of feedback resistor R_{FB}).

The action of the feedback loop around the frontend amplifier 103 causes the noise voltage Vn to create voltage fluctuations in the voltage V_{IN} at the input to the frontend amplifier 103. This noise voltage gives rise to an equivalent noise current, but with a complex transfer function determined by the impedance of the input network at the input to the frontend amplifier, i.e. the network that includes the photodiode capacitance C_{PD}, the inductance L_{PEAK} and the frontend amplifier's own input capacitance C_{IN}.

The impedance of this input network has a dependence on the value of the inductance L_{PEAK}, and a higher value of inductance L_{PEAK} can increase the magnitude of impedance at the input to the TIA frontend amplifier 103, for at least a certain range of frequencies. This can reduce the conversion ratio between the noise voltage Vn and the equivalent noise current and thus mitigates the noise contribution of the amplifier in that frequency range.

However, the input network formed by the inductance L_{PEAK} and surrounding capacitances, i.e. C_{PD} and C_{IN}, is a resonant network. Resonance of this resonant network may be damped, to some extent, by the resistive input impedance of the frontend amplifier 103, but, in general, the effect of the resonance will lead to a resonant peak in the frequency response of the TIA. Whilst this resonant peak could potentially help to usefully extend the bandwidth of the system, the resonance can lead to ringing in the transient response. The ringing can persist for several bit periods, which can lead to a contribution from a data symbol in one bit period contributing to a subsequent bit period. If the ringing occurs within the frequency band of interest for the data signal, it can thus degrade the quality of the data link by introducing ISI (Inter-Symbol Interference) and/or DDJ (Data Dependent Jitter) into the data signal.

Conventionally, therefore, the TIA apparatus 100 would be configured so that inductance L_{PEAK} has a value such that the resonant frequency is outside the data frequency band, i.e. the frequency band for the data signal, and is sufficiently outside this data frequency band such that there is little energy in the data signal to excite the resonance. Any resonance component that does exist is outside the signal band of interest and can be blocked, i.e. removed, by suitable filtering. This need to maintain a sufficiently high resonant frequency, to avoid data signal degradation from transient ringing, is thus conventionally a limiting constraint on the value of inductance allowed between the photodiode and the TIA frontend amplifier.

Embodiments of the present disclosure apply filtering within a backend processing stage of the TIA, where the filtering is configured to have characteristics that at least partially compensate for resonance effects due to the expected resonance at the input to the TIA. In particular, the filtering may be applied with a filter transfer characteristic which is generally an inverse of the expected resonance peak characteristic, so as to flatten the frequency response of the system. The filter may thus be configured to have a local minimum in its frequency response that substantially coincides with the expected frequency of the resonance peak.

The filtering applied is thus not simply filtering to block or remove any signal component in a frequency band that includes the expected resonance frequency of the input network and which is outside the data frequency band. Instead, the filtering has a transfer characteristic that is tuned with respect to the expected resonance response of the input network at the input to the TIA to effectively provide a generally inverse frequency response.

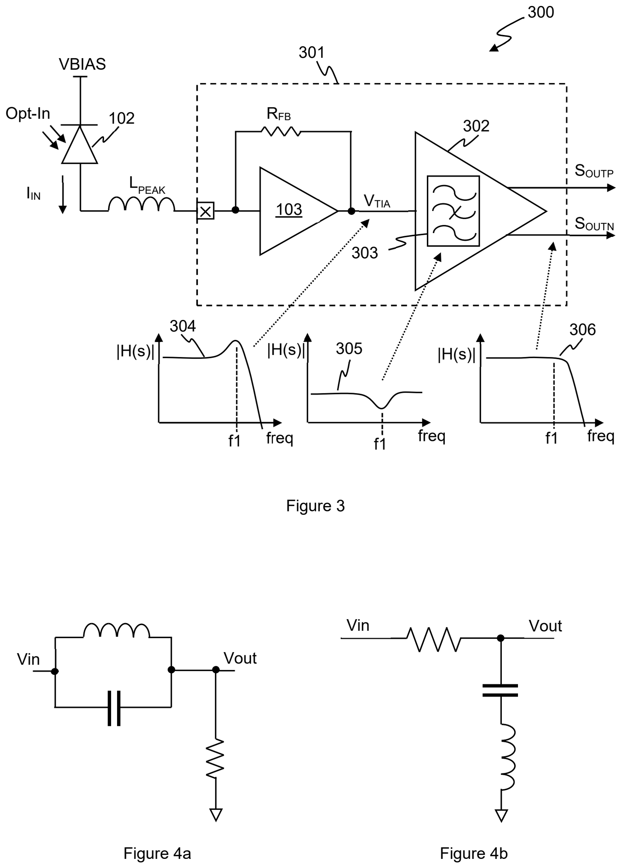

**Figure 3** illustrates one example of a TIA apparatus 300 according to an embodiment, in this example configured as part of an optical receiver, in which the same reference numerals as used previous are used for similar components.

In this example the TIA apparatus 300 has a TIA 300 configured to receive an input current I_{IN} from a photodiode 102 via some inductance L_{PEAK}. The TIA 301 has a frontend amplifier 103 as described with reference to figure 1 and at least one backend stage 302, which may be similar to the backend stage(s) 104 discussed above, except that the backend stage(s) 302 comprises a filter 303, where the filter characteristics are tuned to at least partially compensate for the expected resonance characteristic at the input to the TIA frontend amplifier 103. The filter 303 will thus be referred to herein as a compensation filter.

Figure 3 illustrates an example of the frequency response 304 of the frontend amplifier 103 to an input signal, i.e. the magnitude of the transfer function *H(s).* The frequency response 304 has a signal peak at a frequency f1 arising from the resonance of the input network, i.e. the inductance L_{PEAK} and the capacitances C_{PD} and C_{IN}, at the input to the frontend amplifier 103. To compensate for this resonance characteristic, the compensation filter 303 should ideally have a transfer function that is the inverse of the resonance characteristic. The frequency response of the compensation filter 303 is thus configured to have a dip or trough at the frequency f1, with the dip or trough being substantially the inverse of the resonance peak. In other words, the frequency response of the compensation filter 303 has a local minimum, where the local minimum is configured to substantially coincide with the expected resonance frequency of the input network. The amplitude of the local minimum, i.e. the depth of the dip or trough, may be matched to the expected amplitude or peak height of the resonance peak. The frequency response of the compensation filter 303 may be otherwise substantially flat, at least over the data frequency band of interest for the data signal. Within the data frequency band, the local minimum may thus also be a global minimum (but it will be understood by one skilled in the art that there may be some roll off at frequencies outside the data frequency band of interest, which is why the relevant minimum is described as a local minimum). The overall frequency response 306 of the frontend amplifier 103 and backend stage(s) 302, including the compensation filter 303, is thus compensated for the resonance due to the inductance L_{PEAK} and may, for example, be generally flat (up to the cut-off frequency). Note the shape of the dip around the local minimum may or may not be symmetric.

As the compensation filter 303 at least partially compensates for the resonance due the inductance L_{PEAK} between the photodiode and the TIA frontend amplifier, this inductance can be allowed to have a value that is greater than conventionally would be the case. As noted above, conventionally, the value of this inductance would be limited so as to ensure that the resonance frequency is sufficiently far from the data frequency band of interest for the data signal to avoid ringing effects leading to signal degradation. In embodiments of the present disclosure, the use of the compensation filter 303 allows this constraint to be relaxed and the inductance L_{PEAK} can be configured to have a value that leads to a resonant frequency that is relatively near, or even within, the data frequency band of interest for the data signal, as the effect of this resonance is mitigated by the compensation filter.

Allowing a greater value for the inductance L_{PEAK} is beneficial in terms of reducing IRN as the greater value of the inductance L_{PEAK} can result in an increase in the effective impedance of the input network over at least part of the frequency band of interest for the data signal and hence reduce the noise and improve the sensitivity of the TIA.

The TIA apparatus 300 may thus be configured, in use, with a value for the inductance L_{PEAK} that is beneficial in terms of reducing IRN. As noted above, the value of the inductance L_{PEAK} may be configured to have a value that leads to an expected resonant frequency peak within the data frequency band of the received data signal. The compensation filter 303 is configured to compensate for this expected resonance peak.

In some embodiments the inductance L_{PEAK} may be provided solely by the connective wiring between the photodiode and the input to the TIA frontend amplifier 103. In such embodiments the value of the inductance L_{PEAK} may be set by setting the length of such wiring, for instance by choosing the length of bond-wires or other interconnect connecting the photodiode to the TIA integrated circuit. The length of such bond wires may therefore be chosen to be longer than necessitated by the physical dimensions of the assembly, in order to provide a desired value of inductance. In some embodiments, however, an inductor, i.e. a component specifically configured to act as an inductor, could be added in series in this path. Such an inductor could be formed as an integrated component which forms part of an integrated circuit with the TIA 301 or as a discrete, off-chip, component. Some embodiments thus relate to a TIA apparatus having a frontend amplifier stage, wherein the frontend amplifier stage is connected to an input node for receiving an input current via an inductor.

As noted above, the compensation filter 303 results in a local minimum, i.e. a dip or trough, in the frequency response. Note that the compensation filter 303 does not, at normal expected input signal levels, result in a complete null at the local minimum, i.e. the compensation filter will pass some signal component at the frequency of the local minimum, but just with a reduced gain compared to the rest of the frequency band. The reduced gain at the local minimum is thus finite and configured to counteract the peaking due to the resonance of the input network.

Note that whilst, in some embodiments, the compensation filter 303 may operate to provide attenuation across a range of frequencies to provide the local minimum in its frequency response, in some embodiments the compensation filter 303 may provide some amplification for at least some signal components and the extent of amplification and/or attenuation may vary with frequency such that the frequency response exhibits a local minimum, i.e. trough or dip, at the desired frequency. As used here, a reference to a reduced gain will thus be taken to cover an increased attenuation or a reduced amplification.

In some embodiments the peaking due to the resonance of the input network may be relatively mild, having a modest Q factor, and thus the amplitude of the local minimum of the compensation filter 303, i.e. the depth of the trough in the frequency response, may be relatively low or minimal. However, even where the compensation filter 303 has a low or minimal amplitude of local minimum, and thus a relatively minor effect on signal amplitude, the presence of the compensation filter 303 having a local minimum tuned to the expected resonance peak frequency can improve the phase characteristics of the output from the compensation filter, e.g. by compensating for group delay, and so provide an improved flatness of the phase response, which reduces signal degradation due to ISI or DDJ.

In some embodiments, the compensation filter 303 may be a resonant filter which is matched to the resonant response of the input network, i.e. the inductance L_{PEAK} and capacitances C_{PD} and C_{IN}. The parameters of the compensation filter 303 are selected so that the local minimum in the frequency response of the filter, within the frequency band of interest, matches the resonant peak, i.e. effectively mirrors the resonance peak, in the frequency response of the TIA frontend amplifier 103. In terms of the s-domain response, the inductance of the input network can be seen as introducing a pair of complex conjugate poles into the transfer function of the frontend amplifier 103. The compensation filter 303 may thus be configured so as to introduce a corresponding pair of complex conjugate zeroes. Ideally, the compensation filter will be tuned so that complex zeroes exactly match the complex poles so that they cancel out, eliminating the resonance introduced by the inductor, however practical considerations of component tolerance and variation with operating conditions such as temperature may mean that perfect cancellation may not be possible across the range of expected operating conditions. However, provided that the Q factor of the resonant peak is modest, even approximate matching of the complex zeroes with the expected complex poles is sufficient to substantially flatten the frequency response of the output from the compensation filter 303, and the TIA 301, and suppress ringing in the transient response.

The compensation filter 303 may be arranged as one of a number of backend processing stages of the TIA 301 and may be located in a single-ended or differential signal domain, i.e. upstream or downstream of a single-ended-to-differential conversion stage, if present. The compensation filter 303 may be configured as part of a backend processing stage providing more than one function, e.g. amplification in addition to the filtering.

There are various ways in which a compensation filter could be implemented. In some examples, the compensation filter 303 may be based on the principles of a notch filter. As will be understood by one skilled in the art, notch filters are a type of band-stop filter that provide a relatively narrow stopband in the filter response, which thus has a dip or trough in the frequency response. Conventional notch filters, however, typically provide a null response at the notch frequency, i.e. provide total attenuation at the relevant frequency. As noted above, the frequency response of the compensation filter 303 does not provide a complete null at the local minimum. In some respects, the compensation filter 303 can be thought of as a type of notch filter that provides a partial, or finite, notch characteristic, such that there is still a relatively significant signal component which is passed at the notch frequency. In general, however, the general design principles for notch filters can be used for the compensation filter 303.

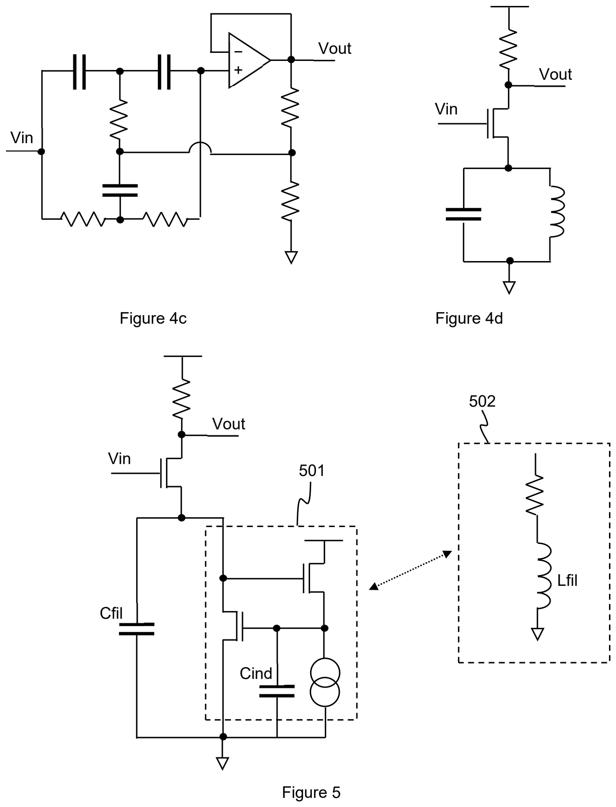

**Figures 4a to 4d** illustrate four examples of general designs of filters that could be used as a basis for the compensation filter 303, depending on the particular use case. Figures 4a and 4b illustrate passive LC (inductor-capacitor) resonant filters in parallel and series configurations respectively. Figure 4c illustrates a twin-T filter architecture, with a non-inverting op-amp buffer and feedback via a potential divider. Figure 4d illustrates an active filter design using a parallel LC network as frequency-dependent degeneration for a common-source FET amplifier, which is equally applicable to a common-emitter amplifier. The parallel LC network has an impedance characteristic that comprises a local maximum at its resonant frequency. When such a network is configured for degeneration of a common-source or common-emitter amplifier, the frequency response of the amplifier will comprise a local minimum, corresponding to the local maximum of the impedance of the LC network. It is assumed that the power supply and DC voltage component of Vin are suitably chosen to bias the transistor at a favourable operating point. One skilled in the art will be aware of how such filters could be implemented to match an expected resonance characteristic and that additional series or parallel resistances could be used to modify the width and depth of the local minimum, i.e. the Q factor and degree of relative attenuation of the dip in the frequency response.

**Figure 5** illustrates a practical example of a suitable compensation filter, which is similar to the degenerated common-source (or common-emitter) amplifier illustrated in figure 4d but in which the inductor is replaced with an active inductor 501. An active inductor, as will be understood by one skilled in the art, is an arrangement or network of components that do not actually comprise an inductor, but which provide a small-signal impedance characteristic comprising a virtual inductance component. For integrated circuit applications this can be advantageous in some cases as providing an inductor with the required inductance may require a relatively significant circuit area and thus add to the area and/or cost of the circuit, whereas active inductor network may be implemented in a smaller circuit area and/or with lower cost. Figure 5 illustrates one example of an active inductor with FETs as the active devices and a capacitance Cind. While the transistors shown in Figure 5 and related diagrams are depicted as FETs, the techniques and topologies under consideration are equally applicable to circuits using bipolar transistors in place of FETs. This active inductor 501 can be approximately modelled as a small-signal equivalent network 502 comprising an inductance Lfil with a value approximately proportional to the capacitance Cind, and a series resistance that provides an element of damping. Again, DC biasing of Vin is assumed to be appropriate to bias the transistors at suitable operating points. One skilled in the art will be aware of other examples of active inductors that could be used in other implementations.

For the compensation filters discussed with reference to figures 4a-d and figure 5, the characteristic of the filter response can be tuned by appropriate selection of the parameters, e.g. inductance, capacitance, resistance etc. of the various components as would be understood by one skilled in the art. These parameters may be selected to match the filter characteristics to the expected resonance characteristics, i.e. so that filter transfer function corresponds generally to the inverse of the resonance peaking at the frontend.

In some cases, the TIA apparatus may be intended for use in an application where all the parameters of the input network for the TIA are known in advance, e.g. where it is known that the TIA will be used with a particular type of photodiode with a known photodiode capacitance and the type and length of the interconnect between the photodiode and TIA is also known, preferably having been selected to provide an inductance value L_{PEAK} that results in low IRN and hence high sensitivity . In such a case, the resonance characteristics of the input network can be determined, e.g. through appropriate modelling/simulation, and the compensation filter parameters chosen accordingly.

In some cases, however, the TIA circuit may be manufactured for applications where a range of possible input networks could be implemented, e.g. where the photodiode used could be selected by a device manufacturer from a range of different photodiodes and the type and/or length of interconnection may vary. In which case, a typical photodiode diode capacitance may be assumed and a value of inductance L_{PEAK} selected which is achievable and which leads to good noise performance. The compensation filter may then be tuned to the resonance expected based on these defined values, i.e. the assumed values, and the TIA may be supplied to a device manufacturer along with recommendations as the value of input inductance, or length of the interconnect, that would lead to optimal performance.

In some embodiments, however, the compensation filter may be configurable so that filter response can be tuned in use, i.e. so that the shape of the filter response, i.e. of the local minimum, can be controllably varied. For example, the compensation filter could be configured so that at least one of a centre frequency of the dip or trough, the width of the dip or trough and the depth of the dip or trough, is variable, or in other words so that at least some of the poles and zeros in the s-domain can be varied. This can allow the filter response of the compensation filter to be effectively configured at the time of device manufacturer so as to be better tuned to compensate for the actual resonance characteristics of the input network.

The filter parameters could be tuned by the use of components with variable values. For instance, for the example of figure 5, where one terminal of each of the capacitors Cfil and Cind is an AC ground, one or both of these capacitances Cfil and Cind could be implemented as variable capacitances. This would allow the value of Cfil or the value of the effective inductance Lfil of the active inductor to be varied respectively. There are various ways in which variable capacitances could be implemented, for instance, by controlling switching of arrays of capacitors of different values.

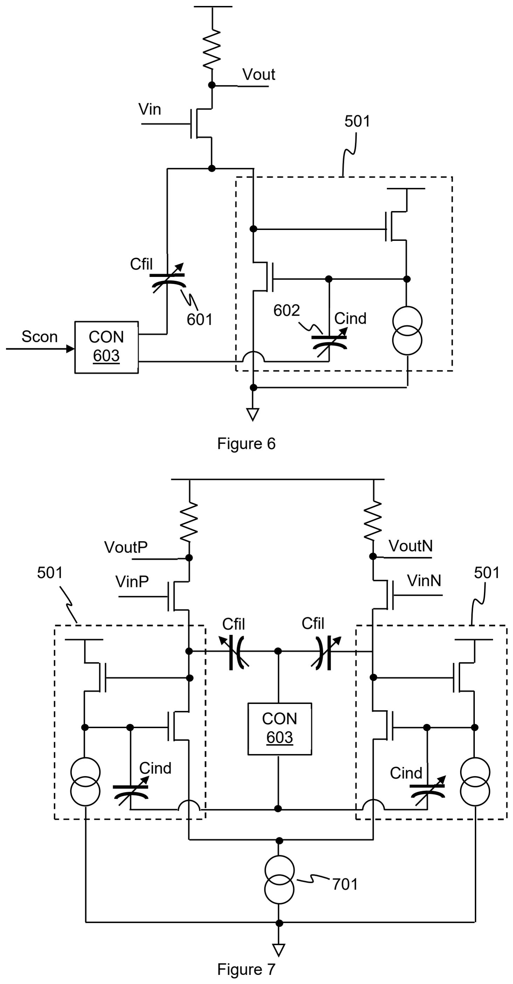

**Figure 6** illustrates one example of a tunable compensation filter which is similar to that described in figure 5, but wherein the capacitances Cfil and Cind are each variable. In the example of figure 6, the capacitances Cfil and Cind are provided by respective varactors 601 and 602, which may, for example, comprise a MOS varactor whose capacitance is variable by means of a DC control voltage. The DC control voltages for the varactors 601 and 602 may be controlled by a controller 603 based on a control signal Scon.

As noted above, the controller 603 may control the DC control voltages for the varactors 601 and 602, and hence the capacitance values of Cfil and Cind, based on the control signal to tune the compensation filter response to appropriately match the resonance characteristic for the resonant network at the input to the TIA. The control signal may thus comprise some settings that are programmable by a device manufacturer and/or which may be determined as part of a calibration process, which could be a factory calibration at the time of device manufacture and/or which could be part of some autocalibration process that could be repeated periodically to adapt for any changes. Additionally or alternatively the controller 603 may be configured to dynamically vary the capacitance values of Cfil and Cind in use, for instance to adapt for changes in the characteristics of the input resonance and/or filter response arising from changes in operating conditions, such as temperature or supply voltage or input signal level. The control signal Scon could thus be indicative of the relevant operating condition, e.g. temperature, so as to allow the control the adapt the compensation filter appropriately. In some implementations the control signal could comprise some feedback signal indicative of how well the compensation filter is compensating for the resonant peak.

As noted above, the compensation filter may be implemented in a single-ended signal domain or a differential-signal domain and a differential implementation can be advantageous in some applications for noise rejection. Figure 7 illustrates an example of a differential filter suitable for use as the compensation filter 303. The compensation filter of figure 7 essentially comprises a filter as discussed with reference to figure 6 for each of the positive and negative signal components of the differential input and thus has variable capacitances implemented by varactors so as to allow tuning of the filter properties. The differential compensation filter of figure 7 also includes a current source 701 which is shared between the two active inductors 501 which provides a convenient means of control the DC bias currents of the active devices.

In general, therefore, embodiments relate to the inclusion of a compensation filter, in a TIA apparatus, in particular in a backend stage of a TIA circuit (i.e. downstream of the frontend TIA amplifier), where the compensation filter has a frequency response with a local minimum. This permits a larger value of an input series inductance L_{PEAK} than would otherwise be appropriate, allowing for a greater suppression of the input-referred noise contributed by the TIA frontend amplifier. If the compensation filter is well optimized to counteract the peaking in the TIA frequency response introduced by L_{PEAK}, then the overall sensitivity of the TIA may be improved due to the reduction of input noise without a consequential impairment to signal integrity. Such optimization may be facilitated by provision of a means of electrical adjustment or tuning of the compensation filter parameters, e.g. via variable capacitance. The increased TIA input series inductance may be satisfied by increasing the length of interconnecting wiring between the photodiode and the TIA IC, and/or by the inclusion of a discrete inductor, e.g. an on-chip inductor, coupled in series with the photodiode.

The TIA circuitry may form part of an optical receiver, together with a suitable photodiode. However, the principles are applicable to any TIA apparatus where there may be a resonant network at the TIA input and other embodiments relate to other applications.

It will be understood that the examples and embodiments described above are given by way of example only and those skilled in the art will understand that modifications, variations, additions or alterations may be made to specific embodiments described, or alternative embodiments may be implemented, without departing from the scope of the appended claims.

It should be noted that as used herein, unless expressly stated otherwise, the word "comprising" does not exclude the presence of other elements or steps other than those listed, references to an element or feature in the singular does not exclude the possibility of a plurality of such elements or features, and that recitation of different features or elements in the appended claims does not necessarily imply separate components; a single component or unit may fulfil the function of several elements recited in a claim. Any reference signs in the appended claims shall not be construed so as to limit their scope.

## Claims

1. A transimpedance amplifier circuit (301) comprising:
a frontend amplifier (103) configured to receive an input current (I_{IN}) from an input terminal and output a corresponding voltage (V_{TIA}); and
at least one processing stage (302) configured to process the voltage output from the frontend amplifier;
wherein the at least one processing stage comprises a filter (303) configured to provide a filter response having a frequency response with a local minimum.

2. The transimpedance amplifier circuit of claim 1 wherein the transimpedance amplifier circuit is configured to process a signal comprising data within a data frequency band and wherein the filter is configured such that the local minimum is within the data frequency band.

3. The transimpedance amplifier circuit of claim 1 or claim 2 wherein the filter is configured such that the filter response (305) at least partly compensates for a resonant peak in the frequency response (304) from the frontend amplifier due to an expected resonance at the input to the frontend amplifier.

4. The transimpedance amplifier circuit of any of claims 1 to 3 wherein the filter is configured such that the local minimum substantially corresponds to an inverse of a resonant peak in the frequency response of the frontend amplifier that would be expected, in use, with a series inductance of a first defined value connected to the input terminal.

5. The transimpedance amplifier circuit of any of claims 1 to 4 wherein the filter is configured such that the filter response (305) comprises two complex conjugate zeroes in the s-domain which are matched to two complex conjugate poles in a transfer characteristic of the frontend amplifier that would occur, in use, with a series inductance of a first defined value connected to the input terminal.

6. The transimpedance amplifier circuit of any of claims 1 to 5 further comprising an inductance in series between the input terminal and the frontend amplifier, wherein said inductance in series between the input terminal and the frontend amplifier comprises at least part of an input resonant network and where the filter is configured such that the local minimum substantially corresponds to an inverse of a resonant peak of said input resonant network.

7. The transimpedance amplifier circuit of any of claims 1 to 6 wherein the filter (303) comprises a notch filter with a non-zero transfer function at a notch frequency (fl) of the notch filter.

8. The transimpedance amplifier circuit of any of claims 1 to 7 wherein the filter comprises a passive LC filter.

9. The transimpedance amplifier circuit of any of claims 1 to 8 wherein the filter comprises a common source or common emitter amplifier, further comprising a frequency-dependent degeneration network comprising a parallel combination of an inductor and a capacitor.

10. The transimpedance amplifier circuit of any of claims 1 to 8 wherein the filter comprises a first capacitance (Cfil; 601) and an active inductor network (501) each connected to a first filter node, wherein the first filter node is coupled to a source of a common-source amplifier or an emitter of a common-emitter amplifier.

11. The transimpedance amplifier circuit of claim 10 wherein the active inductor network comprises a second capacitance (Cind; 602).

12. The transimpedance amplifier circuit of claim 11 wherein at least one of the first capacitance (Cfil; 601) and second capacitance (Cind; 602) are configured to be controllably variable so as to vary the filter response of the filter.

13. The transimpedance amplifier circuit of any of claims 1 to 12 wherein at least one parameter of the filter is controllably variable so as to vary the filter response of the filter.

14. The transimpedance amplifier circuit of claim 13 further comprising a controller (603) for controlling, in use, the at least one parameter of the filter such that the local minimum in the filter response at least partially compensates for a peak in the frequency response of the frontend amplifier due to a resonance at the input to the frontend amplifier.

15. A data receiver apparatus (300) comprising:
the transimpedance amplifier circuit (301) of any of claims 1 to 14;
a data receiver (102) configured to configured to receive a modulated data signal and generate a corresponding current; and
an electrical interconnect for connecting an output of the data receiver to the input terminal of the transimpedance amplifier circuit;
wherein the data receiver and electrical interconnect form at least part of an input resonant network and wherein the apparatus is configured such that the local minimum in filter response corresponds to an inverse of a resonant peak in the frequency response of said input resonant network.
